# EUROPEAN PATENT APPLICATION

(11) **EP 3 395 904 A1**
(43) Date of publication of application: **31.10.2018**
(21) Application number: 16878512.9
(22) Date of filing: 14.12.2016
(51) Int. Cl.: C08L 83/06, C08G 77/14, H01L 33/56

(54) **SILICONE RESIN COMPOSITION AND USE THEREOF**

(30) Priority: 21.12.2015 JP 2015248967
(71) Applicant: Sumitomo Chemical Company, Limited, Tokyo 104-8260 (JP)
(72) Inventor: HOTTA, Shohei, Tsukuba-shi, Ibaraki 300-3294 (JP); TAKASHIMA, Masayuki, Osaka-shi Osaka 554-8558 (JP)
(74) Representative: Winter, Brandl, Fürniss, Hübner, Röss, Kaiser, Polte - Partnerschaft mbB
(86) International application number: PCT/JP2016/087242
(87) International publication number: WO 2017/110621

(57) **Abstract**

Provided is a silicone resin composition useful for production of a silicone-based resin cured product which shows high thermal shock resistance.

A silicone resin composition comprising a silicone resin, wherein
silicon atoms contained in the resin composition essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
side chains bonding to the silicon atoms include an alkyl group having 1 to 3 carbons and an alkoxy group having 1 or 2 carbons, and a molar ratio of alkoxy groups contained therein is 5 or more to 100 of alkyl groups contained therein.

## Description

### TECHNICAL FIELD

The present invention relates to a silicone resin composition and use of the same. More specifically, the present invention relates to a silicone resin composition, a silicone-based resin cured product, an encapsulating material for a semiconductor light-emitting element, a method for producing a silicone-based resin cured product, and a method for producing a semiconductor light-emitting device.

### BACKGROUND ART

In recent years, UV (ultraviolet)-LEDs are beginning to appear on the market. For encapsulation of a UV-LED, a quartz glass is generally used. However, a quartz glass is expensive, and has a problem of low UV light extraction efficiency in relation to the refractive index. In light of this, it has been proposed to encapsulate a UV-LED with a silicone-based resin cured product.

For example, Patent Document 1 describes using a UV transparent polysilsesquioxane glass having an absorption coefficient of 5 cm⁻¹ or less at a wavelength of 230 to 850 nm as an encapsulating material.

### PRIOR ART DOCUMENT

### PATENT DOCUMENTS

Patent Document 1: JP-A-2013-253223

### SUMMARY OF THE INVENTION

### PROBLEMS TO BE SOLVED BY THE INVENTION

However, when the above silicone-based resin cured product is used as an encapsulating material for a UV-LED, the thermal shock resistance is not always sufficient.

Therefore, it is an object of the present invention to provide a silicone resin composition useful for production of a silicone-based resin cured product which shows high thermal shock resistance. It is also an object of the present invention to provide a silicone-based resin cured product which shows high thermal shock resistance, an encapsulating material for a semiconductor light-emitting element comprising the silicone-based resin cured product, a method for producing a silicone-based resin cured product, and a method for producing a semiconductor light-emitting device.

### MEANS FOR SOLVING THE PROBLEMS

The present invention provides the following [1] to [11].
[1] A silicone resin composition comprising the following silicone resin B, wherein
   silicon atoms contained in the resin composition essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
   side chains bonding to the silicon atoms include an alkyl group having 1 to 3 carbons and an alkoxy group having 1 or 2 carbons, and a molar ratio of alkoxy groups contained therein is 5 or more to 100 of alkyl groups contained therein.
   Silicone resin B:
   A silicone resin, wherein silicon atoms contained therein essentially consist of at least one kind of silicon atoms selected from the group consisting of A1 silicon atoms and A2 silicon atoms, and A3 silicon atoms,
   a ratio of the content of the A3 silicon atoms to the total content of the A1 silicon atoms, the A2 silicon atoms and the A3 silicon atoms is 30 mol% or more and less than 60 mol%, and the silicone resin has a weight-average molecular weight of 1500 or more.

   A1 silicon atom denotes a silicon atom in the structural unit represented by the following formula (A1) bonding to one oxygen atom which bonds to a silicon atom in other structural unit, one R¹ and two R²s, or a silicon atom in the structural unit represented by the following formula (A1') bonding to one bonding hand which bonds to an oxygen atom that bonds to a silicon atom in other structural unit, one R¹ and two R²s.
   A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R².
   A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹.
   R¹ represents an alkyl group having 1 to 3 carbons, and R² represents an alkoxy group having 1 or 2 carbons or a hydroxyl group. 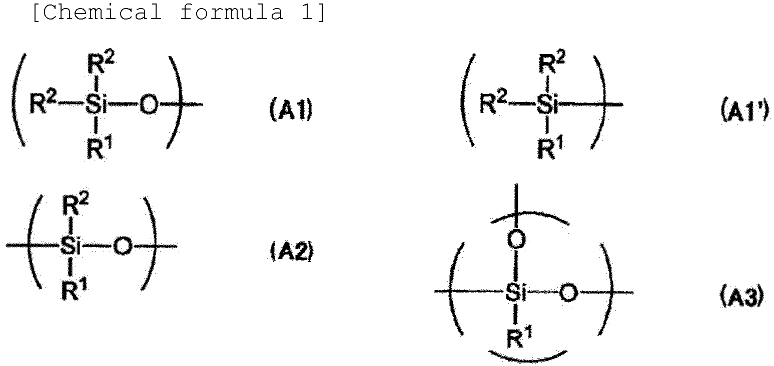
[2] The silicone resin composition according to [1], wherein a molar ratio of hydroxyl groups contained in side chains bonding to the silicon atoms is 10 or more to 100 of the alkyl groups contained therein.
[3] The silicone resin composition according to [1] or [2], further comprising the following silicone resin A.
   Silicone resin A:
   A silicone resin, wherein silicon atoms contained therein essentially consist of at least one kind of silicon atoms selected from the group consisting of A1 silicon atoms and A2 silicon atoms, and A3 silicon atoms, a ratio of the content of the A3 silicon atoms to the total content of the A1 silicon atoms, the A2 silicon atoms and the A3 silicon atoms is 60 mol% or more and 90 mol% or less, and the silicone resin has a weight-average molecular weight of 1500 or more and 8000 or less.
   A1 silicon atom, A2 silicon atom and A3 silicon atom have the same meanings as described above.
[4] The silicone resin composition according to any one of [1] to [3], further comprising the following silicone resin C.
   Silicone resin C:
   A silicone resin having a rate of reduction of mass of less than 5%, as measured by raising the temperature of the silicone resin from a room temperature to 200°C at a temperature ramp-up rate of 5°C/min. and then retaining the silicone resin for 5 hours in air at 200°C.
[5] The silicone resin composition according to [4], further comprising a solvent, wherein a ratio of the total content of the silicone resin A, the silicone resin B, the silicone resin C, and the solvent is 80% by mass or more to the whole amount of the silicone resin composition.
[6] A silicone-based resin cured product, wherein
   silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
   at least one part of the silicone-based resin cured product has a Shore hardness of A70 or less as measured in conformity with JIS K6253-3:2012, and a Shore hardness of D40 or more after incubation at 150°C for 10 hours as measured in conformity with JIS K6253-3:2012.
   A1 silicon atom, A2 silicon atom and A3 silicon atom have the same meanings as described above.
[7] An encapsulating material for a semiconductor light-emitting element, comprising the silicone-based resin cured product according to [6].
[8] A method for producing a silicone-based resin cured product having a Shore hardness of A70 or less as measured in conformity with JIS K6253-3, comprising a step of curing the silicone resin composition according to any one of [1] to [5] with a curing condition of 50°C or more and less than 200°C.
[9] The method for producing a silicone-based resin cured product according to [8], wherein the curing condition is a condition of incubation at 80°C or more and 180°C or less for 1 hour or more and 15 hours or less.
[10] A method for producing a semiconductor light-emitting device, wherein
   the semiconductor light-emitting device comprises a substrate, a semiconductor light-emitting element disposed on the substrate, and an encapsulating part disposed so as to cover a surface of the semiconductor light-emitting element, and
   the semiconductor light-emitting element is surrounded by the substrate and the encapsulating part and encapsulated,
   the method comprising a step of applying the silicone resin composition according to any one of [1] to [5] so as to cover the surface of the semiconductor light-emitting element, and
   a step of forming the encapsulating part by curing the silicone resin composition with a curing condition of 50°C or more and less than 200°C so as to have a Shore hardness of A70 or less as measured in conformity with JIS K6253-3:2012.
[11] The method for producing a semiconductor light-emitting device according to [10], wherein the curing condition is a condition of incubation at 80°C or more and 180°C or less for 1 hour or more and 15 hours or less.

### EFFECT OF THE INVENTION

According to the present invention, it is possible to provide a silicone resin composition useful for production of a silicone-based resin cured product which shows high thermal shock resistance. Also, according to the present invention, it is possible to provide a silicone-based resin cured product which shows high thermal shock resistance, an encapsulating material for a semiconductor light-emitting element comprising the silicone-based resin cured product, a method for producing a silicone-based resin cured product, and a method for producing a semiconductor light-emitting device.

### MODE FOR CARRYING OUT THE INVENTION

### [Silicone resin composition]

One embodiment of the present invention is a silicone resin composition comprising the following silicone resin B, wherein
silicon atoms contained in the resin composition essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
side chains bonding to the silicon atoms include an alkyl group having 1 to 3 carbons and an alkoxy group having 1 or 2 carbons, and a molar ratio of alkoxy groups contained therein is 5 or more to 100 of alkyl groups contained therein.

As described above, A1 silicon atom is a silicon atom in the structural unit represented by the formula (A1), or a silicon atom in the structural unit represented by the formula (A1'). A2 silicon atom is a silicon atom in the structural unit represented by the formula (A2). A3 silicon atom is a silicon atom in the structural unit represented by the formula (A3). R¹ represents an alkyl group having 1 to 3 carbons, and R² represents an alkoxy group having 1 or 2 carbons or a hydroxyl group.

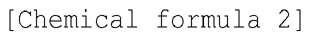

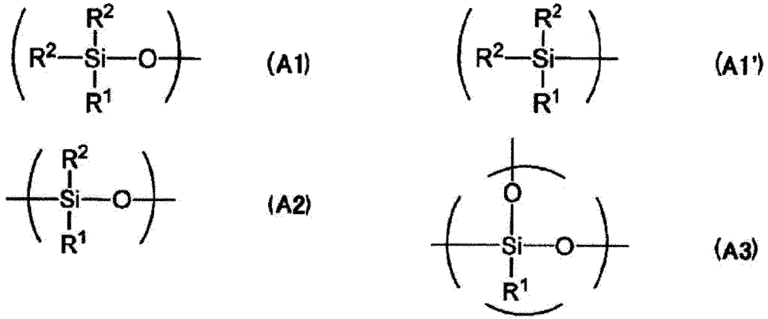

R¹ in the structural unit represented by the formula (A1), R¹ in the structural unit represented by the formula (A1'), R¹ in the structural unit represented by the formula (A2), and R¹ in the structural unit represented by the formula (A3) may be identical or different from each other.

R² in the structural unit represented by the formula (A1), R² in the structural unit represented by the formula (A1'), and R² in the structural unit represented by the formula (A2) may be identical or different from each other.

Two R²s in the structural unit represented by the formula (A1) may be identical or different from each other. Two R²s in the structural unit represented by the formula (A1') may be identical or different from each other.

In the present embodiment, preferably, a molar ratio of hydroxyl groups contained in side chains bonding to the silicon atoms is 10 or more to 100 of the alkyl groups contained therein.

As will be described later, a silicone resin composition which is one embodiment of the present invention is useful for production of a silicone-based resin cured product which shows high thermal shock resistance. Further, since the silicone-based resin cured product which is one embodiment of the present invention has high UV transmissivity and high UV resistance (light resistance), it can be favorably used as an encapsulating material for a UV-LED.

In the present description, the expression "silicone-based resin cured product has high thermal shock resistance" means that cracking is unlikely to occur in the silicone-based resin cured product even when a thermal shock is applied to the silicone-based resin cured product by repeating 100 times a temperature cycle of standing still for 30 minutes at -30°C then for 30 minutes at 85°C, for example.

In the present description, the expression "silicone-based resin cured product has high UV transmissivity" means that deterioration such as decoloring and occurrence of cracking is low in the silicone-based resin cured product even when the silicone-based resin cured product is irradiated with UV light. The term UV light means light having a wavelength of about 250 to 400 nm.

The silicone resin composition of the present embodiment may further comprise the silicone resin A.

In the silicone resin A and the silicone resin B, the structural unit represented by the formula (A1) and the structural unit represented by the formula (A1') form terminals of an organopolysiloxane chain. The structural unit represented by the formula (A3) forms a branched-chain structure by an organopolysiloxane chain. That is, the structural unit represented by the formula (A3) forms a part of a network structure or a ring structure in the silicone resin B and the silicone resin A.

The silicon atoms contained in the silicone resin A and the silicone resin B essentially consist of at least one kind of silicon atoms selected from the group consisting of A1 silicon atoms and A2 silicon atoms, and A3 silicon atoms. The expression "essentially consist of at least one kind of silicon atoms selected from the group consisting of A1 silicon atoms and A2 silicon atoms, and A3 silicon atoms" means that 80 mol% or more of silicon atoms contained in the silicone resin A and the silicone resin B are either of A1 silicon atoms, A2 silicon atoms and A3 silicon atoms, preferably, 90 mol% or more are either of A1 silicon atoms, A2 silicon atoms and A3 silicon atoms, and more preferably 95 mol% or more are either of A1 silicon atoms, A2 silicon atoms and A3 silicon atoms.

A silicone resin can be synthesized by using as a starting material an organic silicon compound corresponding to each of the aforementioned structural units constituting the silicone resin and having a functional group capable of generating a siloxane bond. The "functional group capable of generating a siloxane bond" may be, for example, a halogen atom, a hydroxyl group or an alkoxy group. Examples of the organic silicon compound corresponding to the structural unit represented by the formula (A3) include organotrihalosilane and organotrialkoxysilane. A silicone resin can be synthesized through reaction by the hydrolysis condensation method using organic silicon compounds which are starting materials in a ratio corresponding to an existence ratio of each structural unit. By appropriately selecting the organic silicon compounds which are starting materials, it is possible to adjust the existence ratio of A3 silicon atoms contained in the silicone resin. The silicone resin thus synthesized is industrially commercially available as a silicone resin or the like.

### (Silicone resin A)

The ratio of the content of the A3 silicon atoms to the total content of the A1 silicon atoms, the A2 silicon atoms and the A3 silicon atoms is preferably 70 mol% or more and 85 mol% or less.

In the silicone resins such as silicone resins A to C, the kind and the existence ratio of the functional groups bonding to the silicon atoms can be measured, for example, by using the nuclear magnetic resonance spectrometry (NMR method) . The nuclear magnetic resonance spectrometry (NMR method) is described in detail in various documents and the like, and excusive-use measurement apparatus are widely commercially available. Specifically, the kind and the existence ratio of each functional group in the silicone resin can be measured by dissolving the silicone resin constituting the object of measurement into a specific solvent, giving a strong magnetic field and a high-frequency radio wave to the hydrogen atom nucleus or the silicon atom nucleus in the silicone resin, and resonating the nuclear magnetic moment in the atomic nucleus. A method of measuring the hydrogen atom nucleus is referred to as ¹H-NMR, and a method of measuring the silicon atom nucleus is referred to as ²⁹Si-NMR. As the solvent for use in measurement in the nuclear magnetic resonance spectrometry (NMR method), heavy chloroform, heavy dimethyl sulfoxide, heavy methanol, heavy acetone, heavy water or the like may be selected in accordance with the kind of various functional groups in the silicone resin.

The ratio of the content of the A3 silicon atoms can be determined by dividing the area of the signals assigned to the A3 silicon atoms by the total of the area of the signals assigned to the A1 silicon atoms, the area of the signals assigned to the A2 silicon atoms and the area of the signals assigned to the A3 silicon atoms as determined by using ²⁹Si-NMR measurement.

In the structural units contained in the silicone resin A, R¹ is an alkyl group having 1 to 3 carbons, and is preferably a methyl group. R² is an alkoxy group having 1 or 2 carbons or a hydroxyl group. When R² is an alkoxy group, a methoxy group or an ethoxy group is preferred as the alkoxy group.

The silicone resin A preferably has an organopolysiloxane structure represented by the following formula (1). In the formula (1), R¹ and R² have the same meanings as described above. p¹, q¹, a¹ and b¹ represent arbitrary positive numbers.

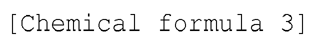

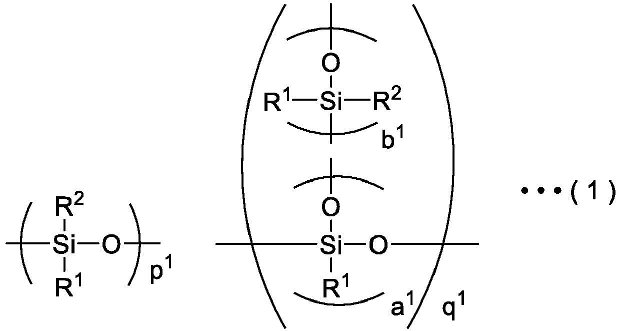

Regarding the existence ratio of the respective structural units in the organopolysiloxane structure represented by the formula (1), the content ratio of the A3 silicon atoms (= y¹/(x¹ + y¹)) to the total content of the number of the A2 silicon atoms: x¹ (= p¹ + b¹ × q¹) and the number of the A3 silicon atoms: y¹ (= a¹ × q¹) is within the range of 0.6 to 0.9, preferably within the range of 0.7 to 0.85, and the numerical values of p¹, q¹, a¹, and b¹ can be appropriately adjusted so that such a range is achieved.

A silicone-based resin cured product in which the organopolysiloxane chains are configured in a net form can be produced by curing the silicone resin A because the silicone resin A has a high existence ratio of the A3 silicon atoms. When the existence ratio of the A3 silicon atoms is higher than the aforementioned range (0.6 to 0.9), the thermal shock resistance of the silicone-based resin cured product can be low, whereas when the existence ratio of the A3 silicon atoms is lower than the aforementioned range (0.6 to 0.9), the UV resistance of the silicone-based resin cured product can be low.

When the silicone resin A is a silicone resin having an organopolysiloxane structure in which the existence ratio of the A3 silicon atoms in the formula (1) is within the aforementioned range (0.6 to 0.9), the cured product of the silicone resin A tends to have high UV resistance.

The numbers of A2 silicon atoms and A3 silicon atoms per one molecule of the silicone resin A can be adjusted by controlling the molecular weight of the resin having an organopolysiloxane structure represented by the formula (1) . In the present embodiment, it is preferable that the total of the number of A2 silicon atoms and the number of A3 silicon atoms per one molecule of the silicone resin A is 5 or more.

The weight-average molecular weight (Mw) of the silicone resin A is 1500 or more and 8000 or less. When the weight-average molecular weight of the silicone resin A is too small, the UV resistance of the cured product of the silicone resin composition of the present embodiment tends to be low. When the weight-average molecular weight of the silicone resin A is within the above range, a cured product being more excellent in the UV resistance can be produced. The weight-average molecular weight of the silicone resin A is preferably 2000 or more and 5000 or less.

As a weight-average molecular weight (Mw) of a silicone resin, it is possible to use a value determined generally by the gel permeation chromatography (GPC) method. Specifically, after a silicone resin is dissolved into a soluble solvent, the resultant solution is passed together with a mobile-phase solvent in a column in which a filler containing a lot of fine holes (pores) is used, and separation is made in accordance with the size of the molecular weight in the column, and the contents of the molecular weight components thus separated are detected by using a differential refractometer, a UV meter, a viscometer, a light-scattering detector or the like as a detector. A GPC dedicated device is widely marketed, and weight-average molecular weight (Mw) is generally measured by standard polystyrene conversion. Weight average molecular weight (Mw) in this description means a measurement by the standard polystyrene conversion.

In measurement of weight-average molecular weight by the GPC method, the solvent for use in dissolving the silicone resin is preferably the same solvent as the mobile-phase solvent for use in the GPC measurement. Specific examples of the solvent include tetrahydrofuran, chloroform, toluene, xylene, dichloromethane, dichloroethane, methanol, ethanol and isopropyl alcohol. The column for use in the GPC measurement is commercially available, and an appropriate column may be used in accordance with the presumed weight-average molecular weight.

The silicone resin A can be synthesized by using as a starting material an organic silicon compound corresponding to each of the aforementioned structural units constituting the silicone resin A and having a functional group capable of generating a siloxane bond. The "functional group capable of generating a siloxane bond" represents the same meaning as described above. Examples of the organic silicon compound corresponding to the structural unit represented by the formula (A3) include organotrihalosilane and organotrialkoxysilane. The silicone resin A can be synthesized through reaction by the hydrolysis condensation method using such organic silicon compounds which are starting materials in a ratio corresponding to an existence ratio of each structural unit. The silicone resin thus synthesized is industrially commercially available as a silicone resin or the like.

### (Silicone resin B)

The ratio of the content of the A3 silicon atoms to the total content of the A1 silicon atoms, the A2 silicon atoms and the A3 silicon atoms is preferably 35 mol% or more and 55 mol% or less, more preferably 40 mol% or more and 50 mol% or less.

The silicone resin B preferably has an organopolysiloxane structure represented by the following formula (2). In the formula (2), R¹ and R² have the same meanings as described above. p², q², r², a² and b² represent arbitrary positive numbers.

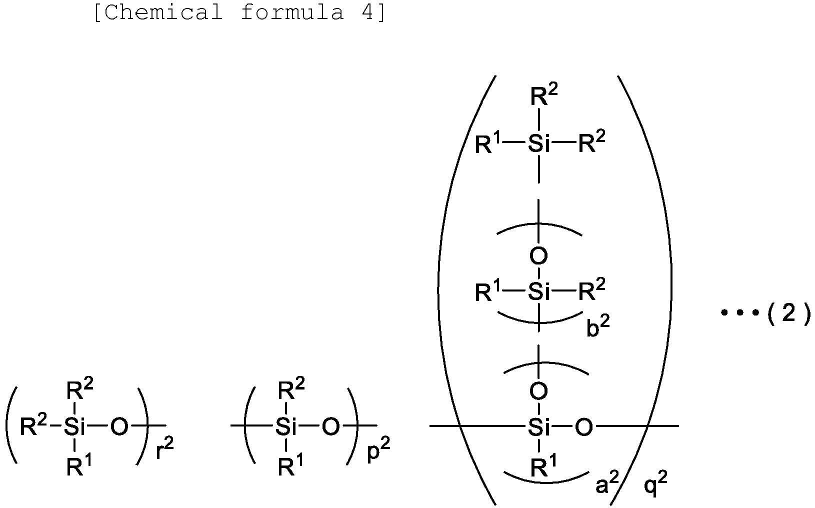

In the organopolysiloxane structure represented by the formula (2), the content ratio of the A3 silicon atoms (= [a² × q²]/[(p² + b² × q²) + a² × q²+ (r² + q²)]) to the total content of the A1 silicon atoms, the A2 silicon atoms, and the A3 silicon atoms is within the range of 0.3 or more and less than 0.6, preferably within the range of 0.35 to 0.55, more preferably within the range of 0.4 to 0.5.

The weight-average molecular weight (Mw) of the silicone resin B is 1500 or more. As will be described later in Examples, when the weight-average molecular weight of the silicone resin B is within the above range, the thermal shock resistance of the cured product of the silicone resin composition of the present embodiment tends to improve. The weight-average molecular weight of the silicone resin B is preferably 1500 or more and 8000 or less, more preferably 1500 or more and 7000 or less, further preferably 1500 or more and 6000 or less.

The numbers of A1 silicon atoms, A2 silicon atoms and A3 silicon atoms per one molecule of the silicone resin B can be adjusted by controlling the molecular weight of the resin having an organopolysiloxane structure represented by the formula (2) . In the present embodiment, it is preferable that the total of the number of the A1 silicon atoms, the number of the A2 silicon atoms and the number of the A3 silicon atoms in one molecule of the silicone resin B is 5 or more.

By curing the mixture of the silicone resin A and the silicone resin B, it is possible to obtain a cured product having further improved thermal shock resistance, and adhesiveness between the cured product and the substrate or the semiconductor light-emitting element without impairing the high UV resistance of the silicone resin A.

The silicone resin B can be synthesized by using as a starting material an organic silicon compound corresponding to each of the aforementioned structural units constituting the silicone resin B and having a functional group capable of generating a siloxane bond. The "functional group capable of generating a siloxane bond" represents the same meaning as described above. Examples of the organic silicon compound corresponding to the structural unit represented by the formula (A3) include organotrihalosilane and organotrialkoxysilane. The silicone resin B can be synthesized through reaction by the hydrolysis condensation method using such organic silicon compounds which are starting materials in a ratio corresponding to an existence ratio of each structural unit. The silicone resin thus synthesized is industrially commercially available as a silicone resin or the like.

The silicone resin composition of the present embodiment is obtained by mixing the silicone resin A and the silicone resin B in any desired ratio. The ratio of the content of silicone resin A (fractional resin content) to the total content of the silicone resin A and the silicone resin B is preferably 5 to 95% by mass, more preferably 30 to 90% by mass. When the fractional resin content of the silicone resin A is within the above range, there is a tendency that a silicone-based resin cured product having excellent thermal shock resistance and excellent UV resistance can be obtained. In the present description, the fractional resin content is calculated based on the mass of the silicone resin excluding the mass of the solvent when the silicone resin is dissolved in the solvent.

The total content (resin fraction) of the silicone resin A and the silicone resin B contained in the silicone resin composition of the present embodiment is preferably 15% by mass or more, more preferably 50% by mass or more.

A method for mixing the silicone resin A and the silicone resin B is not particularly limited, so that any of the methods that are generally carried out in mixing two or more kinds of polymers may be used. For example, the silicone resin A and the silicone resin B can be mixed by dissolving the silicone resin A and the silicone resin B, together with other resin as necessary, in the same organic solvent.

The organic solvent is preferably an organic solvent having a boiling point of 100°C or higher. Specific examples of organic solvents include glycol ether solvents such as ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether and dipropylene glycol monobenzyl ether; and glycol ester solvents (produced by adding an acetic acid group to the glycol ether solvents mentioned above) such as ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate and ethylene glycol monobenzyl ether acetate. Among these, ethylene glycol monobutyl ether, diethylene glycol monobutyl ether and ethylene glycol monobutyl ether acetate are more preferable.

### (Silicone resin C)

The silicone resin composition of the present embodiment may further comprise the silicone resin C. The silicone resin C is a silicone resin having a rate of reduction of mass of less than 5%, as measured by raising the temperature of the silicone resin from a room temperature to 200°C at a temperature ramp-up rate of 5°C/min. and then retaining the silicone resin for 5 hours in air at 200°C. The temperature raising step from a room temperature to 200°C at a temperature ramp-up rate of 5°C/min. is normally carried out in air.

It can be mentioned that the silicone resin C has little unreacted functional groups, and is thermally stable. Therefore, the silicone resin C is less likely to degrade even when it is irradiated with UV light. Therefore, by blending the silicone resin C, it is possible to further improve the UV resistance of the silicone-based resin cured product.

The silicone resin C is not particularly limited as long as it is thermally stable, and specifically, silicone resins having a fine particulate structure that is called silicone rubber powder or silicone resin powder can be used.

Among the silicone resins having a fine particulate structure, globular silicone resin powder composed of a polysilsesquioxane resin in which the siloxane bond has a three-dimensional network structure represented by (RSiO_{3/2}) is preferred. In (RSiO_{3/2}), R is preferably a methyl group.

When the silicone resin C is globular silicone resin powder, a mean particle diameter of the silicone resin powder is preferably 0.1 to 50 µm, more preferably 1 to 30 µm, further preferably 2 to 20 µm.

When the mean particle diameter of the silicone resin powder is within the above range (0.1 to 50 µm), there is a tendency that occurrence of peeling in the interface between the silicone-based resin cured product and the substrate, cloudiness of the silicone-based resin cured product, and deterioration in light permeability of the silicone-based resin cured product can be easily suppressed.

The mean particle diameter of the silicone resin powder can be measured, for example, by a particle size distribution measuring device utilizing "laser diffraction scattering method" as a measurement principle. This technique measures a particle diameter distribution of particles by utilizing that diffracted light and scattering light are emitted in various directions depending on the sizes of particles when the particles are irradiated with a laser beam (monochromatic light), and can determine a mean particle diameter from the distribution state of the diffracted light and the scattering light. Devices that utilize "laser diffraction scattering method" as a measurement principle are commercially available from many manufacturers.

When the silicone resin composition of the present embodiment is a silicone resin composition liquid comprising the silicone resin A, the silicone resin B, the silicone resin C and a solvent for dissolving or dispersing these silicone resins, the total content of the silicone resin A, the silicone resin B, the silicone resin C and the solvent contained in the silicone resin composition liquid is preferably 80% by mass or more, more preferably 90% by mass or more.

The ratio of the content of the silicone resin C (fractional resin content) to the total content of the silicone resin A, the silicone resin B and the silicone resin C is preferably 20 to 90% by mass, more preferably 40 to 80% by mass. When the fractional resin content of the silicone resin C is within the above range, there is a tendency that a silicone-based resin cured product having excellent thermal shock resistance and excellent UV resistance in good balance can be obtained.

### (Other additives)

The silicone resin composition of the present embodiment may comprise a silane coupling agent, a catalyst for curing, or other additives.

### <<Silane coupling agent>>

The silane coupling agent provides an effect of improving adhesion between the silicone-based resin cured product, and the semiconductor light-emitting element or the substrate. The silane coupling agent is preferably a silane coupling agent having at least one group selected from the group consisting of vinyl group, epoxy group, styryl group, methacryl group, acryl group, amino group, ureido group, mercapto group, sulfide group and isocyanate group, more preferably a silane coupling agent having an epoxy group or a mercapto group.

Specific examples of the silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane, 3-mercaptopropyltrimethoxysilane and the like.

When the silicone resin composition of the present embodiment comprises a silane coupling agent, a silicon atom contained in the silane coupling agent is also detected as a signal of ²⁹Si-NMR. Therefore, in the present description, a signal of the silane coupling agent is also included at the time of calculating a signal area (a signal area attributed to A1 silicon atom, a signal area attributed to A2 silicon atom, and a signal area attributed to A3 silicon atom) of the silicone resin composition.

The content of the silane coupling agent in the silicone resin composition of the present embodiment is preferably 0.0001 to 1.0 parts by mass, more preferably 0.001 to 0.1 parts by mass, to 100 parts by mass of the total content of the silicone resin A and the silicone resin B, or to 100 parts by mass of the total content (resin fraction) of the silicone resin A, the silicone resin B and the silicone resin C. When the content of the silane coupling agent is higher than the above range, transparency of the silicone-based resin cured product may in some cases decrease because the silane coupling agent itself absorbs light.

The silane coupling agent may be used while it is mixed with the silicone resin composition of the present embodiment. Also, it is possible to preliminarily adhere a silane coupling agent on the surface of the semiconductor light-emitting element or the substrate by coating or a dipping treatment, and then form the silicone resin composition of the present embodiment by potting or the like and cure the silicone resin composition.

### <<Catalyst for curing>>

In general, a catalyst for curing such as an acidic compound, an alkaline compound and a metallic compound is sometimes added to the silicone resin composition. It is preferable that the silicone resin composition of the present embodiment does not comprise a catalyst for curing, however, when the silicone resin composition of the present embodiment comprises a catalyst for curing, an acidic compound or an alkaline compound is preferred as the catalyst for curing. The content of the catalyst for curing is preferably 0.5% by mass or less, more preferably 0.05% by mass or less, to the total content of the silicone resin A and the silicone resin B, or to the total content (resin fraction) of the silicone resin A, the silicone resin B and the silicone resin C. When the silicone resin composition of the present embodiment comprises a metallic catalyst as a catalyst for curing, the content of the metallic catalyst is preferably 0.05% by mass or less, more preferably 0.01% by mass or less, further preferably 0.001% by mass or less.

### <<Other additives>>

Examples of other additives include silicone resins other than the silicone resin A, the silicone resin B and the silicone resin C, silicone oligomers, and silicone compounds. Specific examples of other additives include general modifier silicone compounds that are industrially, commercially available. By comprising such a modifier silicone compound in the silicone resin composition of the present embodiment, it is possible to impart the flexibility to the silicone-based resin cured product. Examples of the modifier silicone compound include polymers, oligomers and the like that have a dialkylsiloxane structure including R₂SiO_{2/2} (wherein, R represents an alkyl group) as a backbone.

When the silicone resin composition of the present embodiment comprises a silicone compound, a silicon atom contained in the silicone compound is also detected as a signal of ²⁹Si-NMR. Therefore, in the present description, a signal of the silicone compound is also included at the time of calculating a signal area (a signal area attributed to A1 silicon atom, a signal area attributed to A2 silicon atom, and a signal area attributed to A3 silicon atom) of the silicone resin composition.

The content of the silicone compound in the silicone resin composition of the present embodiment is preferably 0.1 to 20 parts by mass, more preferably 0.5 to 10 parts by mass, to 100 parts by mass of the total content of the silicone resin A and the silicone resin B, or to 100 parts by mass of the total content (resin fraction) of the silicone resin A, the silicone resin B and the silicone resin C. When the content of the silicone compound is higher than the above range, transparency of the cured product may in some cases be deteriorated.

Other examples of the additives include a defoaming agent for suppressing air bubbles that are generated at the time of mixing the silicone resin composition.

### [Silicone-based resin cured product]

One embodiment of the present invention is a silicone-based resin cured product, wherein
silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
at least one part of the silicone-based resin cured product has a Shore hardness of A70 or less as measured in conformity with JIS K6253-3:2012, and a Shore hardness of D40 or more after incubation at 150°C for 10 hours as measured in conformity with JIS K6253-3:2012.

The silicone-based resin cured product of the present embodiment is produced by half-curing the silicone resin composition as described above. That is, the silicone-based resin cured product of the present embodiment is at least partially a silicone-based resin cured product having a Shore hardness of A70 or less before incubation at 150°C for 10 hours as measured in conformity with JIS K6253-3:2012. In this description, "half-cured" means the state of not completely cured. That is, in the silicone-based resin cured product of the present embodiment, the curing reaction that has stopped on the way further advances by incubation at 150°C for 10 hours. In the silicone-based resin cured product of the present embodiment, the region in the half-cured state may be a part or the whole.

The silicone-based resin cured product of the present embodiment has a half-cured region having a Shore hardness of A70 or less as measured in conformity with JIS K6253-3:2012. In the half-cured region, the curing reaction further advances by incubation at 150°C for 10 hours, and the Shore hardness becomes D40 or more as measured in conformity with JIS K6253-3:2012.

The silicone-based resin cured product of the present embodiment exhibits flexibility (stress relaxation) by being in a half-cured state at least partially. Therefore, as will be described later in Examples, the silicone-based resin cured product of the present embodiment is remarkably excellent in the thermal shock resistance.

It is sometimes the case that a silicone resin composition having a ratio of the content of the A3 silicon atoms to the total content of the A1 silicon atoms, the A2 silicon atoms and the A3 silicon atoms of less than 50 mol% cannot keep any desired shape when it is half-cured to have a Shore hardness of A70 or less. Therefore, when such a silicone resin composition is used for production of the semiconductor light-emitting device as will be described later, it is sometimes the case that the surface of the semiconductor light-emitting element cannot be sufficiently covered, or a desired shape of the semiconductor light-emitting device cannot be achieved.

When the silicone resin composition does not comprise the silicone resin B, or when the molar ratio of alkoxy groups is less than 5 to 100 of alkyl groups in the side chains bonding to silicon atoms constituting the silicone resin composition, the resultant cured product can lack the flexibility as the silicone-based resin cured product, and have low thermal shock resistance.

### [Method for producing silicone-based resin cured product]

One embodiment of the present invention is a method for producing a silicone-based resin cured product having a Shore hardness of A70 or less as measured in conformity with JIS K6253-3:2012, the method comprising a step of curing the silicone resin composition described above with a curing condition of 50°C or more and less than 200°C.

By the production method of the present embodiment, it is possible to produce a silicone-based resin cured product in a half-cured state as described above. The half-cured silicone-based resin cured product has flexibility and has high thermal shock resistance. As described above, it is preferable that the silicone resin composition of the present embodiment does not comprise a catalyst for curing.

In the curing condition, the curing temperature is preferably 80°C or more and 180°C or less, more preferably 125°C or more and 150°C or less. The curing time is preferably 1 hour or more and 15 hours or less, more preferably 5 hours or more and 12 hours or less.

The silicone-based resin cured product obtained by the production method of the present embodiment has high thermal shock resistance, and excellent UV resistance, so that it is useful as an encapsulating material for a UV-LED, photo diode, CCD, CMOS and so on, particularly, as an encapsulating material for a UV-LED.

### [Method for producing semiconductor light-emitting device]

One embodiment of the present invention is a method for producing a semiconductor light-emitting device, wherein
the semiconductor light-emitting device comprises a substrate, a semiconductor light-emitting element disposed on the substrate, and an encapsulating part disposed so as to cover a surface of the semiconductor light-emitting element, and
the semiconductor light-emitting element is surrounded by the substrate and the encapsulating part and encapsulated,
the method comprising a step of applying the silicone resin composition according to the present embodiment so as to cover the surface of the semiconductor light-emitting element, and
a step of forming the encapsulating part by curing the silicone resin composition with a curing condition of 50°C or more and less than 200°C to have a Shore hardness of A70 or less as measured in conformity with JIS K6253-3:2012.

The curing condition is preferably a condition of incubating at 80°C or more and 180°C or less for 1 hour or more and 15 hours or less.

By encapsulating a semiconductor light-emitting element on a substrate by the silicone resin composition of the present embodiment, and then curing the silicone resin composition under the aforementioned condition, it is possible to produce a semiconductor light-emitting device comprising the semiconductor light-emitting element encapsulated by the silicone-based resin cured product in a half-cured state. The silicone-based resin cured product has high thermal shock resistance, and excellent UV resistance. Therefore, the semiconductor light-emitting device in which the semiconductor light-emitting element is encapsulated by the silicone-based resin cured product is advantageous in that cracking or peeling are less likely to occur in the boundary between the silicone-based resin cured product and the substrate, and that deterioration in brightness over time of UV light emitted from the element is less likely to occur when it is used as an encapsulating material for UV-LED.

### EXAMPLES

Hereafter, the present invention will be specifically described by showing Examples and Comparative Examples. However, the present invention is not limited to the following Examples.

In the present Example, as a means for measuring the kind of silicon atoms and the existence ratio of substituents in the silicone resin composition, a solution ¹H-NMR method, a solution ²⁹Si-NMR method or a solid ²⁹Si-NMR method was used. For measurement of the molecular weight of the silicone resin, the GPC method was used. The measurement conditions were as follows.

### <Solution ¹H-NMR measurement condition>

Device name: ECA-500 manufactured by JEOL RESONANCE Inc.
Observation nucleus: ¹H
Observation frequency: 500.16 MHz
Measurement temperature: room temperature
Measurement solvent: DMSO-d₆
Pulse width: 6.60 µsec (45°)
Pulse repeating time: 7.0 sec
Accumulation times: 16 times
Sample concentration (sample/measurement solvent) : 300 mg/0.6 mL

### <Solution ²⁹Si-NMR measurement condition>

Device name: 400-MR manufactured by Agilent Technologies Japan, Ltd.
Observation nucleus: ²⁹Si
Observation frequency: 79.42 MHz
Measurement temperature: room temperature
Measurement solvent: CDCl₃
Pulse width: 8.40 µsec (45°)
Pulse repeating time: 15.0 sec
Accumulation times: 4000 times
Sample concentration (sample/measurement solvent) : 300 mg/0.6 mL

### <Solution ²⁹Si-NMR measurement method>

Device name: AVANCE300 400-MR manufactured by Bruker Corporation
Observation nucleus: ²⁹Si
Observation frequency: 59.6 MHz
Measurement temperature: room temperature
Measurement method: DDMAS method
Reference material: hexamethylcyclotrisiloxane
(set at -9.66 ppm, corresponding to setting TSM at 0 ppm)
MAS condition: 3.5 kHz
Pulse width: π/6 (1.4 msec)
Wait time: 20.0 sec
Accumulation times: 4096 times
Sample amount: 180 mg

### <GPC measurement condition>

Apparatus: HLC-8220 manufactured by TOSOH CORPORATION Column: TSKgel Multipore HXL-M×3 + Guard column-MP(XL)
Flow rate: 1.0 mL/min
Detection conditions: RI (polarity +)
Concentration: 100 mg + 5 mL (THF)
Injection amount: 100 µL
Column temperature: 40°C
Eluent: THF

In the present Example, a molar ratio of methyl groups, methoxy groups and hydroxyl groups that bond to silicon atoms existing in the silicone resin composition was measured by the solution ¹H-NMR or the solid ¹³C-NMR measurement. The conditions in each of the measurement methods were as follows.

In the present Example, when a molar ratio of methyl groups, methoxy groups and hydroxyl groups existing in the silicone resin composition is measured for the silicone resin composition containing a silicone resin that is insoluble in a solvent such as the silicone resin C, the silicone resin that is insoluble in a solvent is measured in advance by the solid ¹³C-NMR, or the silicone resin composition is subjected to a centrifugal separation treatment or a filtration treatment to remove the silicone resin that is insoluble in a solvent, and the silicone resin that is insoluble in a solvent is measured by the solid ¹³C-NMR. Thereafter, by combining with the measurement of solid ¹³C-NMR of other silicone resin that is soluble in a solvent, a molar ratio of methyl groups, methoxy groups and hydroxyl groups existing in the silicone resin composition was determined.

At this time, in the obtained NMR spectrum, a peak derived from an alkoxy group such as a methoxy group is detected in a chemical shift of 3.0 ppm to 4.0 ppm, however, a peak derived from a structure of a solvent component, a peak of a silanol group or the like is also detected as a similar chemical shift, and a plurality of peaks can be overlapped. In such a case, a treatment of designating and subtracting a solvent peak by separately conducting NMR measurement of the solvent alone, a treatment of separating the peaks of alkoxy group and silanol group by varying the measurement environmental temperature or the like is generally carried out. Also in the present Example, by conducting such a general treatment, a molar ratio of methoxy group alone was determined.

### <Solution ¹H-NMR measurement condition>

Device name: 400-MR manufactured by Agilent Technologies Japan, Ltd.
Observation nucleus: ¹H
Observation frequency: 399.78 MHz
Measurement temperature: described in Examples and Comparative examples
Measurement solvent: described in Examples and Comparative examples
Pulse width: 6.00 µsec (45°)
Pulse repeating time: 30.0 sec
Accumulation times: 16 times
Sample concentration (sample/measurement solvent) : 100 mg/0.8 mL

### <Solid ¹³C-NMR measurement condition>

Device name: AVANCE300 400-MR manufactured by Bruker Corporation
Observation nucleus: ¹³C
Observation frequency: 75.4 MHz
Measurement temperature: room temperature
Measurement method: DDMAS method
Reference material: adamantane (set at 29.47 ppm, corresponding to setting TMS at 0 ppm)
MAS condition: 10 kHz
Pulse width: π/6 (1.5 msec)
Wait time: 10.0 sec
Accumulation times: 8192 times (measurement of reference)
214 times (measurement of resin C)
16384 times (other measurement)
Sample amount: 85 mg

### [Production example 1]

### (Production of silicone resin composition)

A silicone resin 1 having an organopolysiloxane structure represented by the above formula (1) (Mw = 3500, in the above formula (1), R¹ = methyl group, R² = methoxy group or hydroxyl group) was used as the silicone resin A. The existence ratio of each of the structural units of the silicone resin 1 is shown in Table 1.

**[Table 1]**

| | A2 silicon atom | | A3 silicon atom |
|---|---|---|---|
| Structural unit | 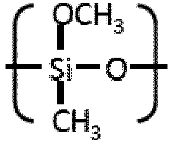 | 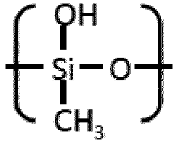 | 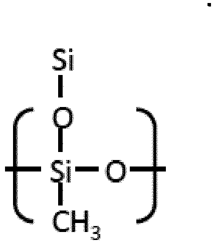 |
| Existence ratio | 0.08 | 0.15 | 0.77 |

A rate of reduction of mass was 10.3%, as measured by raising the temperature of the silicone resin 1 from the room temperature to 200°C at a temperature ramp-up rate of 5°C/min. and then retaining the the silicone resin 1 for 5 hours in air at 200°C.

A silicone resin 2 having an organopolysiloxane structure represented by the above formula (2) (Mw = 4500, in the above formula (2), R¹ = methyl group, R² = methoxy group) was used as the silicone resin B. The existence ratio of each of the structural units of the silicone resin 2 is shown in Table 2.

**[Table 2]**

| | A1 silicon atom | A2 silicon atom | A3 silicon atom |
|---|---|---|---|
| Structural unit | 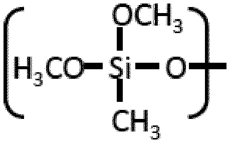 | 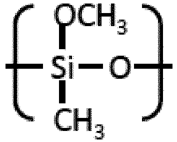 | 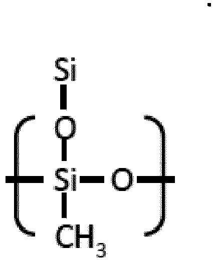 |
| Existence ratio | 0.06 | 0.49 | 0.45 |

A rate of reduction of mass was 35.5%, as measured by raising the temperature of the silicone resin 2 from the room temperature to 200°C at a temperature ramp-up rate of 5°C/min. and then retaining the silicone resin 2 for 5 hours in air at 200°C.

The silicone resin composition of Production example 1 was prepared by mixing 42 g of the silicone resin 1 as the silicone resin A, 28 g of the silicone resin 2 as the silicone resin B, and 30 g of propyl acetate as a solvent.

A molar ratio of methyl groups, methoxy groups and hydroxyl groups that bond to silicon atoms existing in the silicone resin composition of Production example 1 was measured by ¹H-NMR, to find that methoxy groups were 24.5 to 100 of methyl groups, and hydroxy groups were 12.0 to 100 of methyl groups. At this time, the measurement temperature of the solution ¹H-NMR was room temperature, and the solvent for measurement was DMSO-d₆.

### [Production example 2]

### (Production of silicone resin composition)

As silicone resin C, a silicone resin (Product name: "KMP-701", R in the formula: RSiO_{3/2} is a methyl group, and the resin has a methoxy group and a hydroxyl group as a functional group capable of generating a siloxane bond.) available from Shin-Etsu Chemical Co., Ltd. was used. A rate of reduction of mass was 0.6%, as measured by raising the temperature of KMP-701 from the room temperature to 200°C at a temperature ramp-up rate of 5°C/min. and then retaining KMP-701 for 5 hours in air at 200°C.

The silicone resin composition of Production example 2 was prepared by mixing 42 g of the silicone resin 1 as the silicone resin A, 28 g of the silicone resin 2 as the silicone resin B, 70 g of the KMP-701 (available from Shin-Etsu Chemical Co., Ltd.) as the silicone resin C, and 30 g of propyl acetate as a solvent.

A molar ratio of methyl groups, methoxy groups and hydroxyl groups that bond to silicon atoms existing in the silicone resin composition of Production example 2 was measured by solution ¹H-NMR and solid ¹³C-NMR, to find that methoxy groups were 12.5 to 100 of methyl groups, and hydroxy groups were 15.8 to 100 of methyl groups. At this time, the measurement temperature of the solution ¹H-NMR was room temperature, and the solvent for measurement was DMSO-d₆.

### [Production example 3]

### (Production of silicone resin composition)

Using 0.75 mole of ethyl trimethoxysilane and dilute nitric acid as an acid catalyst, a mixture having a molar ratio of trifunctional silicon alkoxide : water : nitric acid of 1 : 3 : 0.002 was prepared. The obtained mixture was stirred in a closed vessel at 20°C for 3 hours, and then stood still at 60°C for 24 hours to conduct hydrolysis condensation polymerization. Since the obtained reaction liquid separates into a lower layer abundantly containing the condensation polymerization reaction liquid, and an upper layer abundantly containing methanol which is a by-product, the reaction liquid in the lower layer side was taken out with a separating funnel. The obtained reaction liquid in the lower layer side was dried in air at 60°C for 2 hours, and then in vacuo at 40°C for 2 hours, to obtain a silicone resin composition of Production example 3. The silicone resin composition of Production example 3 had a content of the A3 silicon atoms to the total content of the A1 silicon atoms, the A2 silicon atoms and the A3 silicon atoms of 58.7 mol%.

A molar ratio of methyl groups, methoxy groups and hydroxyl groups that bond to silicon atoms existing in the silicone resin composition of Production example 3 was measured by solution ¹H-NMR, to find that methoxy groups were 6.7 to 100 of methyl groups, and hydroxy groups were 36.4 to 100 of methyl groups. The solution ¹H-NMR measurement temperature at this time was 60°C, and the solvent for measurement was DMSO-d₆.

### [Production example 4]

### (Production of silicone resin composition)

A silicone resin 3 having an organopolysiloxane structure represented by the above formula (2) (Mw = 450, in the above formula (2), R¹ = methyl group, R² = methoxy group) was used as the silicone resin B. The existence ratio of each of the structural units of the silicone resin 3 is shown in Table 3.

**[Table 3]**

| | A1 silicon atom | A2 silicon atom | A3 silicon atom |
|---|---|---|---|
| Structural unit | 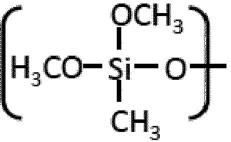 | 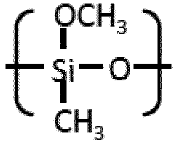 | 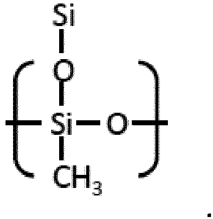 |
| Existence ratio | 0.39 | 0.49 | 0.12 |

A rate of reduction of mass was 89.1%, as measured by raising the temperature of the silicone resin 3 from the room temperature to 200°C at a temperature ramp-up rate of 5°C/min. and then retaining the silicone resin 3 for 5 hours in air at 200°C.

First, 35 g of the silicone resin 1 as the silicone resin A, 3.5 g of the silicone resin 3 as the silicone resin B, and 19 g of isopropyl alcohol as a solvent were mixed.

Then 0.4 g of a commercially available silicone compound that is different from the silicone resin 1 and the silicone resin 3 was added, and dissolved by stirring for 1 hour or more. The commercially available silicone compound was a silicone resin having a ratio of the content of the A3 silicon atoms to the total content of the A1 silicon atoms, the A2 silicon atoms and the A3 silicon atoms of less than 30 mol%, having a weight-average molecular weight of more than 8000 and 15000 or less.

Then to the obtained mixture, 123 g of 2-butoxyethyl acetate, and 0.01 g of 3-glycidoxypropyltrimethoxysilane (silane coupling agent) were added. From the obtained mixture, with use of an evaporator, isopropyl alcohol was distilled off under conditions with a temperature of 70°C and a pressure of 4 kPa until the isopropyl alcohol concentration became 1% by mass or less, thereby yielding a silicone resin composition of Production example 4. The silicone resin composition of

Production example 4 had a content of the A3 silicon atoms to the total content of the A1 silicon atoms, the A2 silicon atoms and the A3 silicon atoms of 65 mol%.

A molar ratio of methyl groups, methoxy groups and hydroxyl groups that bond to silicon atoms existing in the silicone resin composition of Production example 4 was measured by solution ¹H-NMR, to find that methoxy groups were 16.1 to 100 of methyl groups, and hydroxy groups were 23.1 to 100 of methyl groups. The solvent for ¹H-NMR measurement was DMSO-d₆.

### [Example 1]

### (Production of silicone-based resin cured product)

On an LTCC substrate of 3.5 mm long × 3.5 mm wide (low-temperature co-fired ceramics, available from YOKOWO CO., LTD.), an appropriate amount of the silicone resin composition of Production example 1 was potted (dropped) . Then, the potted silicone resin was cured in a curing condition of incubation at 150°C for 10 hours, to obtain a silicone-based resin cured product of Example 1.

The Shore hardness measured for the silicone-based resin cured product of Example 1 was A55. Then, the silicone-based resin cured product of Example 1 was further incubated at 150°C for 10 hours (incubation treatment), and the Shore hardness measured again was D67. That is, the Shore hardness increased by the incubation treatment, compared with before the incubation treatment. This result shows that the silicone-based resin cured product of Example 1 was in a half-cured state. Measurement of the Shore hardness was conducted in conformity with JIS K6253-3:2012.

### [Example 2]

### (Production of silicone-based resin cured product)

A silicone-based resin cured product of Example 2 was obtained in the same manner as in Example 1 except that the silicone resin composition of Production example 2 was used, and the curing condition of incubation at 125°C for 10 hours was employed.

The Shore hardness measured for the silicone-based resin cured product of Example 2 was A33. Then, the silicone-based resin cured product of Example 2 was further incubated at 150°C for 10 hours (incubation treatment), and the Shore hardness measured again was D57. That is, the Shore hardness increased by the incubation treatment, compared with before the incubation treatment. This result shows that the silicone-based resin cured product of Example 2 was in a half-cured state. Measurement of the Shore hardness was conducted in conformity with JIS K6253-3:2012.

### [Comparative Example 1]

### (Production of silicone-based resin cured product)

A silicone-based resin cured product of Comparative Example 1 was obtained in the same manner as in Example 1 except that the silicone resin composition of Production example 3 was used, and the curing condition of incubation at 160°C for 24 hours was employed. Since the silicone-based resin cured product of Comparative Example 1 breaks at the time of measurement of the Shore hardness, the Shore hardness could not be measured. In the silicone-based resin cured product of Comparative Example 1, cracking occurred. This reveals that the silicone-based resin cured product of Comparative Example 1 is fragile in terms of the strength.

### [Comparative Example 2]

### (Production of silicone-based resin cured product)

A silicone-based resin cured product of Comparative Example 2 was obtained in the same manner as in Example 1 except that the silicone resin composition of Production example 4 was used. Since the silicone-based resin cured product of Comparative Example 2 broke at the time of measurement of the Shore hardness, the Shore hardness could not be measured. In the silicone-based resin cured product of Comparative Example 2, cracking occurred. This reveals that the silicone-based resin cured product of Comparative Example 2 is fragile in terms of the strength.

### [Comparative Example 3]

### (Production of silicone-based resin cured product)

A silicone-based resin cured product of Comparative Example 3 was obtained in the same manner as in Example 1 except that the silicone resin composition of Production example 1 was used, and the curing condition of incubation at 200°C for 10 hours was employed. In the silicone-based resin cured product of Comparative Example3, cracking occurred in the curing step.

### [Test Example 1]

### (Thermal shock test)

For silicone-based resin cured products of Examples and Comparative Examples, a thermal shock was applied by repeating a temperature cycle each consisting of standing still at -30°C for 30 minutes and standing still at 85°C for 30 minutes 100 times, and thermal shock resistance was evaluated. The results of the thermal shock test are shown in Table 4. The results of the thermal shock test revealed that the silicone-based resin cured products of Examples show high thermal shock resistance.

**[Table 4]**

| Silicone-based resin cured product | Silicone resin composition | Curing condition | Results of thermal shock resistance test |
|---|---|---|---|
| Example 1 | Production example 1 | 150°C, 10 hours | No cracking, peeling |
| Example 2 | Production example 2 | 125°C, 10 hours | No cracking, peeling |
| Comparative example 1 | Production example 3 | 160°C, 24 hours | Not tested, cracking occurred in curing step |
| Comparative example 2 | Production example 4 | 150°C, 10 hours | Not tested, cracking occurred in curing step |

### [Test Example 2]

### (Light resistance test)

For silicone-based resin cured products of Examples, UV light with an output power of 150 mW/cm², and a wavelength of 254 to 420 nm was irradiated using a spot UV irradiator SP-9 (available from Ushio, Inc.). For the silicone-based resin cured products after UV light irradiation, decoloring and cracking were microscopically observed, to examine the light resistance (UV resistance) of the silicone-based resin cured products. The results of the light resistance test are shown in Table 5. The results of the light resistance test revealed that the silicone-based resin cured products of Examples show high light resistance (UV resistance).

**[Table 5]**

| Silicone-based resin cured product | Silicone resin composition | Curing condition | Results of thermal shock resistance test |
|---|---|---|---|
| Example 1 | Production example 1 | 150°C, 10 hours | No decoloring, cracking |
| Example 2 | Production example 2 | 125°C, 10 hours | No decoloring, cracking |

### INDUSTRIAL APPLICABILITY

According to the present invention, it is possible to provide a silicone resin composition useful for production of a silicone-based resin cured product which shows high thermal shock resistance. Also, according to the present invention, it is possible to provide a silicone-based resin cured product which shows high thermal shock resistance, an encapsulating material for a semiconductor light-emitting element comprising the silicone-based resin cured product, a method for producing a silicone-based resin cured product, and a method for producing a semiconductor light-emitting device.

## Claims

1. A silicone resin composition comprising the following silicone resin B, wherein
silicon atoms contained in the resin composition essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
side chains bonding to the silicon atoms include an alkyl group having 1 to 3 carbons and an alkoxy group having 1 or 2 carbons, and a molar ratio of alkoxy groups contained therein is 5 or more to 100 of alkyl groups contained therein;
Silicone resin B:
A silicone resin, wherein silicon atoms contained therein essentially consist of at least one kind of silicon atoms selected from the group consisting of A1 silicon atoms and A2 silicon atoms, and A3 silicon atoms,
a ratio of the content of the A3 silicon atoms to the total content of the A1 silicon atoms, the A2 silicon atoms and the A3 silicon atoms is 30 mol% or more and less than 60 mol%, and the silicone resin has a weight-average molecular weight of 1500 or more;
wherein A1 silicon atom denotes a silicon atom in the structual unit represented by the following formula (A1) bonding to one oxygen atom which bonds to a silicon atom in other structural unit, one R¹ and two R²s, or a silicon atom in the structural unit represented by the following formula (A1') bonding to one bonding hand which bonds to an oxygen atom that bonds to a silicon atom in other structural unit, one R¹ and two R²s,
A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R²,
A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹, and
R¹ represents an alkyl group having 1 to 3 carbons, and R² represents an alkoxy group having 1 or 2 carbons or a hydroxyl group.

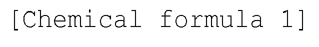

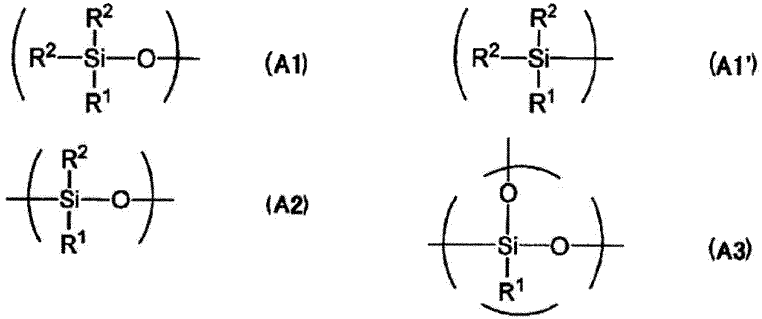

2. The silicone resin composition according to claim 1, wherein a molar ratio of hydroxyl groups contained in side chains bonding to the silicon atoms is 10 or more to 100 of the alkyl groups contained therein.

3. The silicone resin composition according to claim 1 or 2, further comprising the following silicone resin A;
Silicone resin A:
A silicone resin, wherein silicon atoms contained therein essentially consist of at least one kind of silicon atoms selected from the group consisting of A1 silicon atoms and A2 silicon atoms, and A3 silicon atoms, a ratio of the content of the A3 silicon atoms to the total content of the A1 silicon atoms, the A2 silicon atoms and the A3 silicon atoms is 60 mol% or more and 90 mol% or less, and the silicone resin has a weight-average molecular weight of 1500 or more and 8000 or less;
wherein A1 silicon atom denotes a silicon atom in the structural unit represented by the following formula (A1) bonding to one oxygen atom which bonds to a silicon atom in other bonding unit, one R¹ and two R²s, or a silicon atom in the structural unit represented by the following formula (A1') bonding to one bonding hand which bonds to an oxygen atom that bonds to a silicon atom in other structural unit, one R¹ and two R²s,
A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R²,
A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹, and
R¹ represents an alkyl group having 1 to 3 carbons, and R² represents an alkoxy group having 1 or 2 carbons or a hydroxyl group.

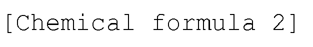

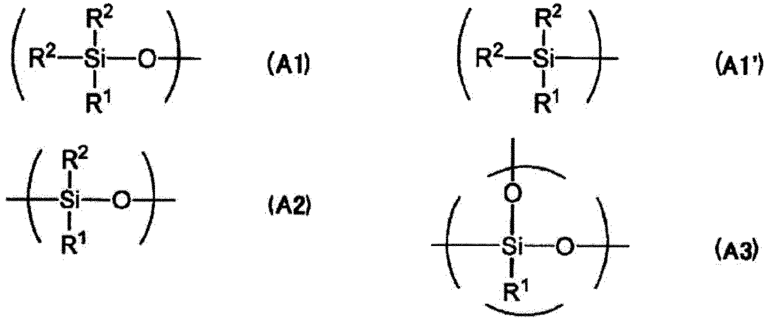

4. The silicone resin composition according to any one of claims 1 to 3, further comprising the following silicone resin C;
Silicone resin C:
A silicone resin having a rate of reduction of mass of less than 5%, as measured by raising the temperature of the silicone resin from a room temperature to 200°C at a temperature ramp-up rate of 5°C/min. and then retaining the silicone resin for 5 hours in air at 200°C.

5. The silicone resin composition according to claim 4, further comprising a solvent, wherein a ratio of the total content of the silicone resin A, the silicone resin B, the silicone resin C and the solvent is 80% by mass or more to the whole amount of the silicone resin composition.

6. A silicone-based resin cured product, wherein
silicon atoms contained therein essentially consist of at least one kind of silicon atoms selected from the group consisting of A1 silicon atoms and A2 silicon atoms, and A3 silicon atoms, and a ratio of the content of the A3 silicon atoms to the total content of the A1 silicon atoms, the A2 silicon atoms and the A3 silicon atoms is 50 mol% or more and 99 mol% or less, and
at least one part of the silicone-based resin cured product has a Shore hardness of A70 or less as measured in conformity with JIS K6253-3:2012, and a Shore hardness of D40 or more after incubation at 150°C for 10 hours as measured in conformity with JIS K6253-3:2012;
wherein A1 silicon atom denotes a silicon atom in the structural unit represented by the following formula (A1) bonding to one oxygen atom which bonds to a silicon atom in other structural unit), one R¹ and two R²s, or a silicon atom in the structural unit represented by the following formula (A1') bonding to one bonding hand which bonds to an oxygen atom that bonds to a silicon atom in other structural unit, one R¹ and two R²s,
A2 silicon atom denotes a silicon atom in the structural unit represented by the following formula (A2) bonding to one oxygen atom which bonds to a silicon atom in other structural unit, one bonding hand which bonds to an oxygen atom that bonds to a silicon atom in other structural unit, one R¹ and one R²,
A3 silicon atom denotes a silicon atom in the structural unit represented by the following formula (A3) bonding to two oxygen atoms each of which bonds to a silicon atom in other structural unit, one bonding hand which bonds to an oxygen atom that bonds to a silicon atom in other structural unit, and one R¹, and
R¹ represents an alkyl group having 1 to 3 carbons, and R² represents an alkoxy group having 1 or 2 carbons or a hydroxyl group.

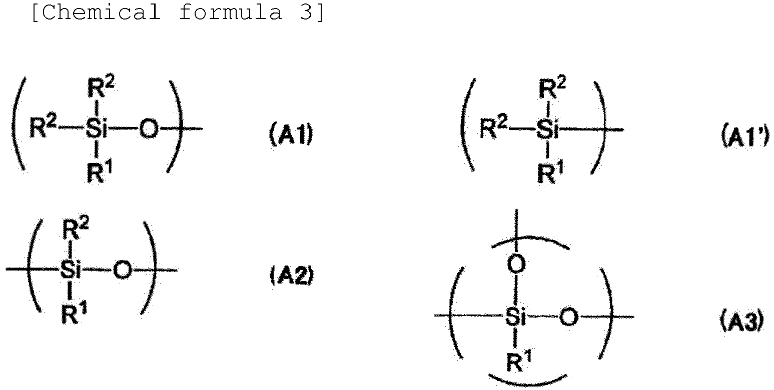

7. An encapsulating material for a semiconductor light-emitting element, comprising the silicone-based resin cured product according to claim 6.

8. A method for producing a silicone-based resin cured product having a Shore hardness of A70 or less as measured in conformity with JIS K6253-3:2012, comprising a step of curing the silicone resin composition according to any one of claims 1 to 5 with a curing condition of 50°C or more and less than 200°C.

9. The method for producing a silicone-based resin cured product according to claim 8, wherein the curing condition is a condition of incubation at 80°C or more and 180°C or less for 1 hour or more and 15 hours or less.

10. A method for producing a semiconductor light-emitting device, wherein
the semiconductor light-emitting device comprises a substrate, a semiconductor light-emitting element disposed on the substrate, and an encapsulating part disposed so as to cover a surface of the semiconductor light-emitting element, and
the semiconductor light-emitting element is surrounded by the substrate and the encapsulating part and encapsulated,
the method comprising a step of applying the silicone resin composition according to any one of claims 1 to 5 so as to cover the surface of the semiconductor light-emitting element, and
a step of forming the encapsulating part by curing the silicone resin composition with a curing condition of 50°C or more and less than 200°C so as to have a Shore hardness of A70 or less as measured in conformity with JIS K6253-3:2012.

11. The method for producing a semiconductor light-emitting device according to claim 10, wherein the curing condition is a condition of incubation at 80°C or more and 180°C or less for 1 hour or more and 15 hours or less.
